# EUROPEAN PATENT APPLICATION

(11) **EP 4 734 714 A1**
(43) Date of publication of application: **29.04.2026**
(21) Application number: 25211064.8
(22) Date of filing: 24.10.2025
(51) Int. Cl.: H10F 71/00

(54) **PHOTOVOLTAIC CELL**

(30) Priority: 25.10.2024 CN 202411506612
(71) Applicant: JINKO SOLAR CO., LTD, ShangRao, Jiangxi 334100 (CN); Zhejiang Jinko Solar Co., Ltd., Haining, Zhejiang (CN)
(72) Inventor: JIN, Jingsheng, 334100 Shangrao, Jiangxi (CN); CUI, Wei, 334100 Shangrao, Jiangxi (CN); LIU, Changming, 334100 Shangrao, Jiangxi (CN); ZHANG, Xinyu, 334100 Shangrao, Jiangxi (CN)
(74) Representative: Balder IP Law, S.L.

(57) **Abstract**

A photovoltaic cell includes: a first surface, a second surface opposing the first surface, and a third surface connecting the first surface with the second surface; a passivation layer, formed over the third surface, wherein the passivation layer comprises a metal oxide, and the metal oxide comprises at least one metal element of Al, Ti, Zn, Zr, Hf, Mo, W, and Ni; and a protective layer, formed on a side of the passivation layer away from the third surface, wherein the protective layer comprises a nitride, and the nitride comprises one element from Group III elements.

## Description

### TECHNICAL FIELD

Embodiments of the present disclosure relate to the field of photovoltaics, and in particular, to a photovoltaic cell, a method for manufacturing the same, and a photovoltaic module.

### BACKGROUND

To reduce issues such as power degradation and hot spots in photovoltaic modules caused by differences in electrical performance of cells, the high current of a one-piece solar cell tends to lead to significant resistive losses. To address the problem of substantial power loss in one-piece solar cells, photovoltaic modules in forms such as half-cut and shingled have continuously gained favor among OEM manufacturers and users.

However, whether for half-cut modules or shingled modules, laser cutting technology is required to divide a one-piece solar cell into two or multiple smaller sliced cells. For the sliced cells, due to mechanical damage during the cutting process and the presence of dangling bonds on the cut surfaces, the efficiency of the sliced cells is reduced, thereby decreasing the power of the module.

### SUMMARY

Embodiments of the present disclosure provide a photovoltaic cell, a method for manufacturing the same, and a photovoltaic module, which can at least improve the photoelectric conversion efficiency of the photovoltaic module comprising the cells.

In one aspect of the present disclosure, some embodiments of the present disclosure provide a photovoltaic cell, comprising: a first surface, a second surface opposite to the first surface, and a third surface connecting the first surface with the second surface; a passivation layer, formed over the third surface, wherein a material of the passivation layer comprises a metal oxide, and the metal oxide comprises at least one metal element of Al, Ti, Zn, Zr, Hf, Mo, W, and Ni; and a protective layer, formed on a side of the passivation layer away from the third surface, wherein a material of the protective layer comprises a nitride, and the nitride comprises one element from Group III.

In some embodiments, the cell is a sliced cell obtained by performing a cutting process on a one-piece cell.

In some embodiments, the third surface is a cut surface of the sliced cell.

In some embodiments, the material of the passivation layer is implemented as aluminum oxide.

In some embodiments, the material of the protective layer is implemented as aluminum nitride or boron nitride.

In some embodiments, an intermediate layer is provided between the passivation layer and the protective layer, wherein a material of the intermediate layer comprises the same metal element as the metal oxide in the passivation layer, and the material of the intermediate layer comprises the same Group III element as the nitride in the protective layer.

In some embodiments, in a direction perpendicular to the third surface, a thickness ratio of the passivation layer to the protective layer ranges from 0.7 to 2.

In some embodiments, in the direction perpendicular to the third surface, a thickness of the protective layer ranges from 10 nm to 100 nm.

In some embodiments, the passivation layer comprises a first sub-passivation layer and a second sub-passivation layer, the first sub-passivation layer is located on the third surface, the second sub-passivation layer is located on a side of the first sub-passivation layer away from the third surface, a material of the first sub-passivation layer comprises silicon oxide, and the material of the second sub-passivation layer comprises a metal oxide.

In some embodiments, the passivation layer further comprises a third sub-passivation layer located between the first sub-passivation layer and the second sub-passivation layer, wherein a material of the third sub-passivation layer comprises a metal silicon oxide, and the metal silicon oxide comprises the same metal element as the second sub-passivation layer.

In some embodiments, in the direction perpendicular to the third surface, the thickness of the protective layer is greater than or equal to a thickness of the second sub-passivation layer.

In some embodiments, the protective layer extends to the first surface of the cell, and/or the protective layer extends to the second surface of the cell.

Some embodiments of the present disclosure further provide a photovoltaic module, including: a cell string comprising at least one photovoltaic cell according to the foregoing embodiments; an encapsulation film covering a surface of the cell string; and a cover plate covering a surface of the encapsulation film away from the cell string.

In another aspect of the present disclosure, some embodiments of the present disclosure provide a method for manufacturing a photovoltaic cell, comprising: providing a one-piece cell; performing a cutting process on the one-piece cell to form a plurality of sliced cells, each of which has a cut surface; forming a passivation layer over the cut surface, wherein a material of the passivation layer comprises a metal oxide, and the metal oxide comprises at least one metal element of Al, Ti, Zn, Zr, Hf, Mo, W, and Ni; and forming a protective layer over a surface of the passivation layer away from the cut surface, wherein a material of the protective layer comprises a nitride, and the nitride comprises one element from Group III.

The technical solution provided in the embodiments of the present disclosure has at least the following advantages:
In the photovoltaic cells provided by the embodiments of the present disclosure, the third surface of the cell is provided with a passivation layer. The passivation layer contains a metal oxide material, and the metal oxide comprises at least one metal element of Al, Ti, Zn, Zr, Hf, Mo, W, and Ni. The metal element in the passivation layer enables the passivation layer itself to possess a high density of fixed charges, generating a strong electric field. This provides effective field-effect passivation for the third surface, resulting in significant band bending between the passivation layer and the third surface. This hinders the migration of minority carriers to the third surface and reduces the concentration of minority carriers at the third surface, thereby lowering the recombination probability of majority and minority carriers at the third surface and improving the efficiency of the photovoltaic cell comprising the cells. Furthermore, when the passivation layer is only present on the third surface of the cell, if the metal oxide in the passivation layer is exposed to air for a long term, it tends to absorb moisture and adsorb airborne particles. This may result in the failure of the passivation layer, impairing the reliability of the photovoltaic cell. In the photovoltaic cells provided by the embodiments of the present disclosure, a protective layer is formed over a surface of the passivation layer away from the third surface. The material of the protective layer comprises a nitride, and the nitride comprises one element from Group III, for example, boron nitride, aluminum nitride, and gallium nitride. These nitrides are all atomic crystals, and therefore exhibit high stability, capable of protecting the inner passivation layer. This prevents the passivation layer from failing due to prolonged exposure to air and moisture, thereby enhancing the stability of the photovoltaic cell.

### BRIEF DESCRIPTION OF THE DRAWINGS

One or more embodiments are illustrated through the figures in the corresponding drawings. These exemplary illustrations do not constitute limitations on the embodiments unless otherwise stated. The figures in the accompanying drawings do not constitute a scale limitation. In order to illustrate the technical solutions in the embodiments of the present disclosure or in the conventional technology more clearly, the drawings used in the description of the embodiments are briefly described below. It is apparent that the drawings in the following description show only some embodiments of the present disclosure, and other drawings may be obtained by those of ordinary skill in the art based on these drawings without any creative efforts.
FIG. 1 is a top view showing a one-piece cell divided into two cells after a cutting process according to an embodiment of the present disclosure;
FIGS. 2 to 7 are schematic cross-sectional views of various photovoltaic cells according to embodiments of the present disclosure;
FIG. 8 is a schematic structural diagram of a photovoltaic module according to an embodiment of the present disclosure; and
FIG. 9 is a flowchart of a method for manufacturing a photovoltaic cell according to an embodiment of the present disclosure.

### DETAILED DESCRIPTION OF THE EMBODIMENTS

As known from the conventional technology, the photoelectric conversion efficiency of solar cells after the cutting process needs to be improved.

Embodiments of the present disclosure provide a photovoltaic cell, a method for manufacturing the same, and a photovoltaic module, which can at least improve the photoelectric conversion efficiency of the photovoltaic module comprising the photovoltaic cells.

In the description of the embodiments of the present disclosure, technical terms such as "first", "second", etc., are merely used for distinguishing different objects and should not be understood as indicating or implying relative importance or implicitly specifying the number, specific order, or priority of the indicated technical features. In the description of the embodiments of the present disclosure, the term "plurality/plural/multiple" refers to two or more, unless otherwise explicitly specified.

The mention of "embodiment" in this paper means that the specific features, structures, or characteristics described in conjunction with the embodiments may be included in at least one embodiment of the present disclosure. The appearance of this phrase at various locations in the specification does not necessarily refer to the same embodiment, nor is it an independent or alternative embodiment that is exclusive with other embodiments. Those skilled in the art can understand explicitly and implicitly that the embodiments described in this paper can be combined with other embodiments.

In the description of the embodiments of the present disclosure, the term "and/or" merely describes the associative relationship between associated objects, indicating that there can be three types of relationships. For example, A and/or B can represent three possible situations: sole existence of A, existence of both A and B, and sole existence of B. Additionally, the character "/" in this paper generally indicates that the associated objects with this character are in an "or" relationship.

In the description of the embodiments of the present disclosure, the technical terms such as "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., indicate the orientation or positional relationship based on the orientation or positional relationship shown in the accompanying drawings. This is solely for the purpose of facilitating the description of the embodiments of the present disclosure and simplifying the description, and in no way indicate or imply that the devices or elements referred to must have a specific orientation, be constructed or operated in a specific orientation. Therefore, these terms should not be construed as a limitation on the embodiments of the present disclosure.

In the drawings corresponding to the embodiments of the present disclosure, the thickness and area of the layers have been exaggerated for better understanding and ease of description. When a component is described as being on another component or on the surface of another component, the component may be "directly" located on the surface of the another component, or a third component may exist between the two components. On the contrary, when one component is described as being at the surface of another component, or when it recites that one component's surface forms or is provided with another component, it indicates that there is no third component between the two components. In addition, when it recites that a component is "roughly" formed on another component, it means that this component is not formed on the entire surface (or front surface) of the another component, nor is it formed on a portion of the edge of the entire surface.

In the description of the embodiments of the present disclosure, when it recites that one component "includes" another component, it does not exclude other components and other components may also be further included unless otherwise stated.

The terms used in the description of various embodiments mentioned in this paper are solely for the purpose of describing specific embodiments and are not intended to be restrictive. As used in the description of the various embodiments and the appended claims, "component" is also intended to cover the plural form, unless the context clearly indicates otherwise.

The following provides a detailed description of the various embodiments of the present disclosure in conjunction with the accompanying drawings. However, those of ordinary skill in the art may understand that in various embodiments of the present disclosure, many technical details have been presented to facilitate a better understanding of the present disclosure by the reader. However, even without these technical details and the various variations and modifications based on the following embodiments, the technical solution claimed in the present disclosure can still be achieved.

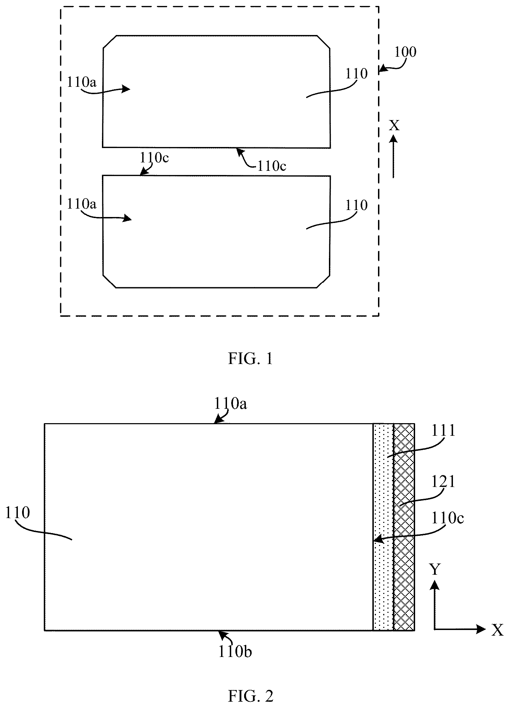

FIG. 1 is a top view showing a one-piece cell divided into two cells after a cutting process according to an embodiment of the present disclosure. FIG. 2 is a schematic cross-sectional view of a first type of photovoltaic cell provided by an embodiment of the present disclosure. Y-axis direction in FIG. 2 corresponds to the top-view direction in FIG. 1.

With reference to both FIG. 1 and FIG. 2, in some scenarios, the photovoltaic cell 100 has a first surface 110a and a second surface 110b opposite to the first surface 110a. After a single cutting process is performed on the photovoltaic cell 100, it is divided into two cells 110 arranged along the X-axis direction. A third surface 110c is formed on the cell 110 through the cutting process. The third surface 110c connects the first surface 110a with the second surface 110b. The third surface 110c formed on the cell 110 through the cutting process contains a large number of dangling bonds and other surface defects caused by mechanical damage in the cutting process. Moreover, due to the various surface defects present on the third surface 110c, impurities are also easily introduced on the third surface 110c. These defects and impurities readily act as recombination centers for electron-hole pairs, shortening the carrier lifetime and leading to a reduction in the photoelectric conversion efficiency of the cell 110. It should be noted that the cutting process includes, but is not limited to, laser cutting. Laser cutting can also easily leave laser-induced damage on the third surface 110c.

With reference to FIG. 1, in some embodiments, the photovoltaic cell 100 may be any of passivated emitter and rear (PERC) cell, passivated emitter and rear totally-diffused (PERT) cell, tunnel oxide passivated contact (TOPCon) cell, heterojunction with intrinsic thin layer (HIT/HJT) cell, or back contact (BC) cell. Correspondingly, the cell 110 can be any of the aforementioned cells.

With reference to FIG. 1, in some embodiments, the one-piece cell 100 may be monocrystalline silicon photovoltaic cell, polycrystalline silicon photovoltaic cell, amorphous silicon photovoltaic cell, or multi-compound photovoltaic cell. Specifically, the multi-compound photovoltaic cell may be cadmium sulfide photovoltaic cell, gallium arsenide photovoltaic cell, copper indium selenide photovoltaic cell, or perovskite photovoltaic cell. Correspondingly, the cell 110 can be any of the aforementioned cells.

With reference to FIG. 2, the photovoltaic cell provided by the embodiments of the present disclosure comprises a cell 110, a passivation layer 111, and a protective layer 121. The cell 110 is obtained by performing a cutting process on a one-piece cell, and the cell 110 has a third surface 110c formed by the cutting process. The passivation layer 111 is formed over the third surface 110c. The material of the passivation layer 111 comprises a metal oxide, and the metal oxide comprises at least one metal element of Al, Ti, Zn, Zr, Hf, Mo, W, and Ni. The protective layer 121 is formed on a side of the passivation layer 111 away from the third surface 110c. The material of the protective layer 121 comprises a nitride, and the nitride comprises one element from Group III.

In the photovoltaic cells provided by the embodiments of the present disclosure, the third surface 110c of the cell 110 is provided with a passivation layer 111. The passivation layer 111 contains a metal oxide material, and the metal oxide comprises at least one metal element of Al, Ti, Zn, Zr, Hf, Mo, W, and Ni. The metal element in the passivation layer 111 enables the passivation layer 111 itself to possess a high density of fixed charges, generating a strong electric field. This provides effective field-effect passivation for the third surface 110c, resulting in significant band bending between the passivation layer 111 and the third surface 110c. This hinders the migration of minority carriers to the third surface 110c and reduces the concentration of minority carriers at the third surface 110c, thereby lowering the recombination probability of majority and minority carriers at the third surface 110c and improving the efficiency of the photovoltaic cell comprising the cells 110. Furthermore, when the passivation layer 111 is only present on the third surface 110c of the cell 110, if the metal oxide in the passivation layer 111 is exposed to air for a long term, it tends to absorb moisture and adsorb airborne particles. This may result in the failure of the passivation layer 111, impairing the reliability of the photovoltaic cell. In the photovoltaic cells provided by the embodiments of the present disclosure, a protective layer 121 is formed over a surface of the passivation layer 111 away from the third surface 110c. The material of the protective layer 121 comprises a nitride, and the nitride comprises one element from Group III, for example, boron nitride, aluminum nitride, and gallium nitride. These nitrides are all atomic crystals, and therefore exhibit high stability, capable of protecting the inner passivation layer 111. This prevents the passivation layer 111 from failing due to prolonged exposure to air and moisture, thereby enhancing the stability of the photovoltaic cell.

In FIG. 1, the cutting process is performed once by way of example. The one-piece cell 100 is thus divided into two sliced cells 110 (i.e., cells 110). Each sliced cell 110 has one third surface 110c. The drawings of the embodiments do not limit the number of performing the cutting process or the cutting methods.

In a specific example, the cutting process may be performed twice. For instance, cross-cutting may be performed on the one-piece cell to divide it into four sliced cells, such that each sliced cell has two intersecting third surfaces. Alternatively, the cutting lines of two cutting processes may be arranged parallel to each other, dividing the one-piece cell into three sliced cells. In this case, the sliced cell in the middle has two third surfaces, while the two sliced cells on either side of the middle one each have one third surface. It can be understood that regardless of the number of the third surfaces of the sliced cell, a passivation layer and a protective layer can be provided on each third surface of the sliced cell. This achieves passivation of the third surface while protecting the passivation layer with the protective layer, thereby improving the efficiency of the photovoltaic cell and enhancing its stability.

In some embodiments, the metal element in the metal oxide material of the passivation layer 111 is Al, that is, the material of the passivation layer 111 is aluminum oxide. On one hand, the aluminum oxide material enables the passivation layer 111 to possess a high density of fixed negative charges (e.g., Qf approximately ranges from 10¹² cm⁻² to 10¹³ cm⁻²), which helps enhance the field passivation effect on the third surface 110c and reduces the recombination probability of carriers at the third surface 110c, thereby improving the photoelectric conversion efficiency of the sliced cell 110. On the other hand, in the technique used to form the passivation layer 111 containing aluminum oxide material, an appropriate amount of hydrogen ions is also incorporated into the passivation layer 111. This enables the passivation layer 111 to provide effective hydrogen passivation for the third surface 110c. The appropriate amount of hydrogen ions in the passivation layer 111 can effectively saturate the dangling bonds on the third surface 110c through migration and also suppress recombination with carriers, ensuring that carriers are effectively collected at the corresponding electrodes in the sliced cell 110, thereby further improving the photoelectric conversion efficiency of the sliced cell 110.

In some embodiments, the metal element in the metal oxide material of the passivation layer 111 is Mo, that is, the material of the passivation layer 111 is molybdenum oxide. On one hand, the molybdenum oxide material enables the passivation layer 111 to possess a relatively high work function, providing a good field passivation effect for the third surface 110c. On the other hand, in the technique used to form the passivation layer 111 containing molybdenum oxide material, an appropriate amount of hydrogen ions is also incorporated into the passivation layer 111, enabling it to provide a good hydrogen passivation effect for the third surface 110c.

It should be noted that the two embodiments described above serve as examples illustrating how the metal oxide material in the passivation layer 111 can achieve effective passivation of the third surface 110c. In practical applications, the metal oxide material may include at least one metal element of Al, Ti, Zn, Zr, or Hf, so that the passivation layer 111 can possess a high density of fixed negative charges, providing effective field passivation for the third surface 110c. The metal oxide material may include at least one metal element of Mo, W, and Ni, so that the passivation layer 111 can possess a high density of fixed positive charges or a high work function, providing effective field passivation for the third surface 110c.

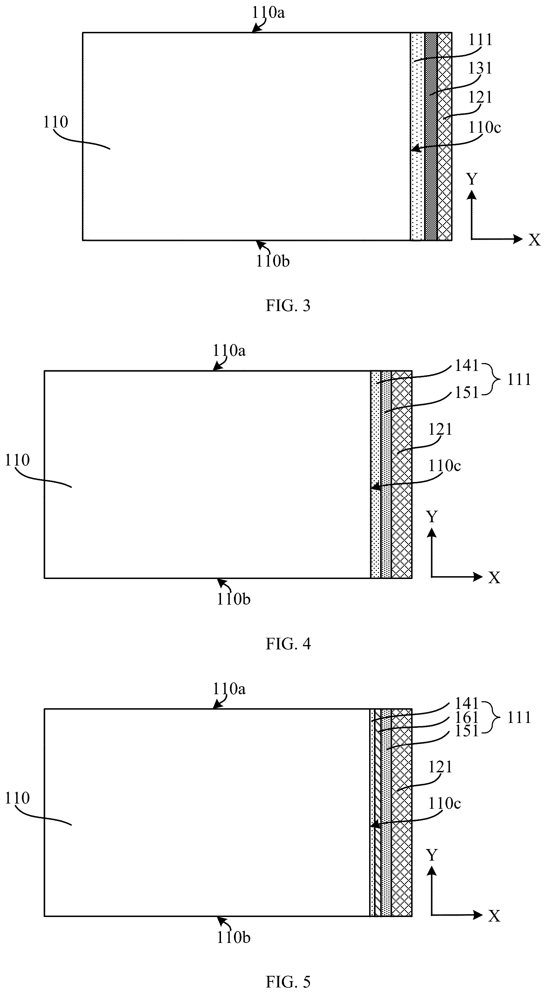

FIG. 3 shows a cross-sectional view of a second type of photovoltaic cell provided by an embodiment of the present disclosure. Y-axis direction in FIG. 3 corresponds to the top-view direction in FIG. 1.

With reference to FIG. 3, in some embodiments, an intermediate layer 131 is provided between the passivation layer 111 and the protective layer 121. A material of the intermediate layer 131 comprises the same metal element as the metal oxide in the passivation layer 111, and the material of the intermediate layer 131 comprises the same Group III element as the nitride in the protective layer 121. The intermediate layer 131, acting as a transition layer between the passivation layer 111 and the protective layer 121, facilitates better lattice matching at the interface between the passivation layer 111 and the protective layer 121. This helps avoid an increase in defects on the third surface 110c due to lattice mismatch, thereby maintaining the excellent passivation effect of the passivation layer 111.

In some scenarios, the protective layer 121 can be formed directly on the surface of the passivation layer 111. The intermediate layer 131 may then be formed through the diffusion of metal elements from the passivation layer 111 into the protective layer 121, and through the diffusion of Group III elements from the protective layer 121 into the passivation layer 111. In some scenarios, the intermediate layer 131 can be formed after the formation of the passivation layer 111 and prior to the formation of the protective layer 121.

In some embodiments, in a direction perpendicular to the third surface 110c, a thickness ratio of the passivation layer 111 to the protective layer 121 ranges from 0.7 to 2. For example, the thickness ration may be 0.7, 0.8, 0.9, 1, 1.3, 1.5, 1.8, or 2. On one hand, the protective layer 121 needs to be sufficiently thick to provide adequate protection for the passivation layer 111. On the other hand, an excessively thick protective layer 121 does not enhance the protective effect but instead increases the cost of the photovoltaic cell. Therefore, the thickness ratio of the passivation layer 111 to the protective layer 121 needs to be within an appropriate range to maintain the protective layer's effective performance while avoiding an increase in the manufacturing cost of the photovoltaic cell.

In some specific examples, in the direction perpendicular to the third surface 110c, the thickness of the protective layer 121 may range from 10 nm to 100 nm, such as 10 nm, 15 nm, 26 nm, 35 nm, 48 nm, 56 nm, 64 nm, 73 nm, 80 nm, 92 nm, or 100 nm.

In the aforementioned embodiments, the passivation layer 111 is exemplified as a single-layer structure. In some embodiments, the passivation layer 111 may also be a multilayer structure.

FIG. 4 shows a structural view of a third type of solar cell provided in an embodiment of the present disclosure. Y-axis direction in FIG. 4 corresponds to the top-view direction in FIG. 1.

Referring to FIG. 4, in a specific example, the passivation layer 111 comprises a first sub-passivation layer 141 and a second sub-passivation layer 151. The first sub-passivation layer 141 is located on the third surface 110c, and the second sub-passivation layer 151 is located on a side of the first sub-passivation layer 141 away from the third surface 110c. A material of the first sub-passivation layer 141 comprises silicon oxide, and the material of the second sub-passivation layer 151 comprises a metal oxide.

The first sub-passivation layer 141, containing silicon oxide material, can provide chemical passivation for the third surface 110c. For example, oxygen atoms in the first sub-passivation layer 141 saturate the dangling bonds on the third surface 110c, which can reduce the defect state density of the third surface 110c, thereby lowering the recombination probability of carriers by reducing recombination centers on the third surface 110c. The second sub-passivation layer 151 contains a metal oxide material, and the metal element in the metal oxide material includes at least one of Al, Ti, Zn, Zr, Hf, Mo, W, and Ni. The metal elements in the second sub-passivation layer 151 enable it to possess a high density of fixed charges. This high density of fixed charges generates a strong electric field, thereby providing excellent field-effect passivation for the third surface 110c, resulting in significant band bending between the second sub-passivation layer 151 and the third surface 110c. This hinders the migration of minority carriers to the third surface 110c and reduces the concentration of minority carriers at the third surface 110c. Consequently, this helps lower the recombination probability of majority and minority carriers at the third surface 110c. As such, the first sub-passivation layer 141 and the second sub-passivation layer 151 work together to significantly improve the photoelectric conversion efficiency of the cell 110, thereby enhancing the photoelectric conversion efficiency of the photovoltaic cell.

FIG. 5 shows a structural view of a fourth type of solar cell provided in an embodiment of the present disclosure. Y-axis direction in FIG. 5 corresponds to the top-view direction in FIG. 1.

Referring to FIG. 5, in a specific example, the passivation layer 111 comprises a first sub-passivation layer 141, a second sub-passivation layer 151, and a third sub-passivation layer 161. The third sub-passivation layer 161 is located between the first sub-passivation layer 141 and the second sub-passivation layer 151. The material of the third sub-passivation layer 161 comprises a metal silicon oxide, and the metal silicon oxide comprises the same metal element as the second sub-passivation layer 151. The third sub-passivation layer 161 serves as a transition layer to improve lattice matching at the interfaces where the first sub-passivation layer 141, the third sub-passivation layer 161, and the second sub-passivation layer 151 sequentially contact. This prevents voids and misalignment at these interfaces, thereby enhancing the film uniformity of the passivation layer 111 itself and improving the interface passivation effect of the passivation layer 111 on the cell 110. Furthermore, the third sub-passivation layer 161 helps enhance the bonding strength between the first sub-passivation layer 141 and the second sub-passivation layer 151, preventing issues such as mutual slippage or delamination between the first sub-passivation layer 141 and the third sub-passivation layer 161, or between the third sub-passivation layer 161 and the second sub-passivation layer 151. This improves the structural stability of the passivation layer 111.

The third sub-passivation layer 161 shares the same silicon and oxygen elements with the first sub-passivation layer 141 but also contains the same metal element as the second sub-passivation layer 151. This allows the third sub-passivation layer 161 to function as a transition layer between the first sub-passivation layer 141 and the second sub-passivation layer 151. Moreover, the oxygen atoms in the third sub-passivation layer 161 can migrate toward the third surface 110c, further saturating the dangling bonds on the third surface 110c. This further reduces the defect state density of the third surface 110c, thereby further decreasing recombination centers on the third surface 110c and lowering carrier recombination probability.

In some embodiments, along the direction from the first sub-passivation layer 141 toward the second sub-passivation layer 151, the silicon content in the third sub-passivation layer 161 gradually decreases, while the metal element content gradually increases. This improves the performance stability of the third sub-passivation layer 161 and avoids performance abruptness caused by sudden changes in elemental composition.

In some embodiments, the second sub-passivation layer 151 may be formed directly on a surface of the first sub-passivation layer 141, with the third sub-passivation layer 161 formed through the diffusion of metal elements from the second sub-passivation layer 151 into the first sub-passivation layer 141. In some embodiments, the third sub-passivation layer 161 can be formed after the formation of the first sub-passivation layer 141 and prior to the formation of the second sub-passivation layer 151.

In some embodiments, along the direction from the first sub-passivation layer 141 toward the second sub-passivation layer 151, the thicknesses of the first sub-passivation layer 141, the third sub-passivation layer 161, and the second sub-passivation layer 151 increase sequentially.

It should be noted that the first sub-passivation layer 141 contains a silicon oxide material. A relatively small thickness of the silicon oxide material ensures effective chemical passivation of the first sub-passivation layer 141 on the third surface 110c, and also simplifies the formation process of the first sub-passivation layer 141. Further, the small thickness of the first sub-passivation layer 141 allows oxygen atoms in the third sub-passivation layer 161 to easily migrate to the third surface 110c in the case that the third sub-passivation layer 161 contains oxygen, further enhancing the chemical passivation effect on the third surface 110c. The third sub-passivation layer 161 serves as a transition layer between the first sub-passivation layer 141 and the second sub-passivation layer 151. The thickness of the third sub-passivation layer 161 needs to be appropriate to facilitate the migration of oxygen atoms from the third sub-passivation layer 161 to the third surface 110c. The second sub-passivation layer 151 contains a metal oxide material, and a greater thickness of the metal oxide layer improves the field-effect passivation on the third surface 110c. Thus, with the second sub-passivation layer 151 having the greatest thickness among the three, the first sub-passivation layer 141 having the smallest thickness, and the third sub-passivation layer 161 having an intermediate thickness, such configuration ensures both effective chemical passivation of the first sub-passivation layer 141 on the third surface 110c and effective field-effect passivation of the second sub-passivation layer 151 on the third surface 110c, and also facilitates the migration of oxygen atoms from the third sub-passivation layer 161 to the third surface 110c.

In some specific embodiments, in the direction perpendicular to the third surface 110c, the thickness of the protective layer 121 is greater than or equal to the thickness of the second sub-passivation layer 151. The material of the second sub-passivation layer 151 is a metal oxide. As the outermost layer of the passivation layer 111, if the metal oxide is exposed to air for a long term, it tends to absorb moisture and adsorb airborne particles, which may result in the failure of the passivation layer 111, impairing the reliability of the photovoltaic cell. The thickness of the protective layer 121 being at least greater than that of the second sub-passivation layer 151 enables the protective layer 121 to provide sufficient protection for the second sub-passivation layer 151, thereby improving the stability of the photovoltaic cell.

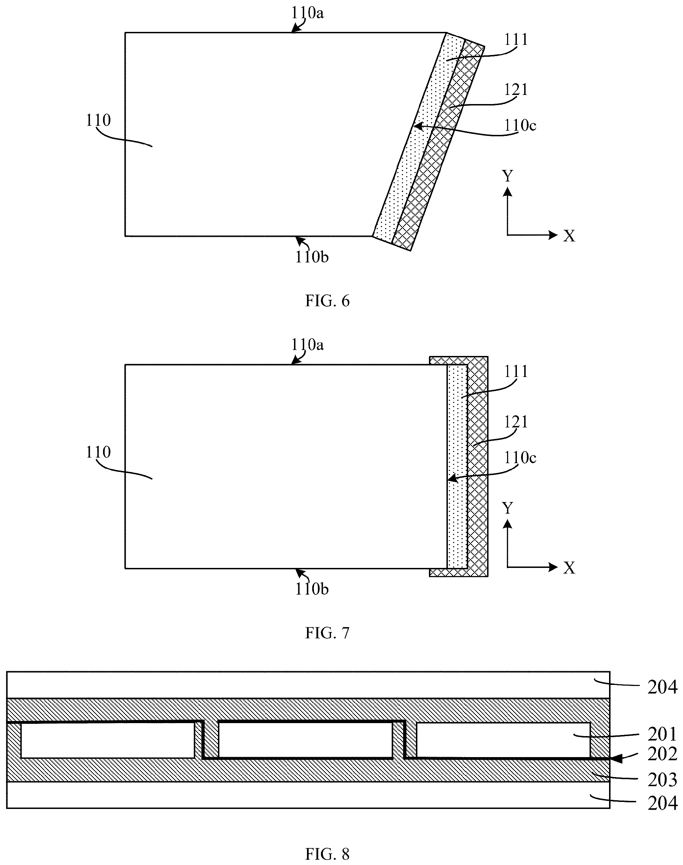

FIG. 6 shows a structural view of a fifth type of solar cell provided in an embodiment of the present disclosure. Y-axis direction in FIG. 6 corresponds to the top-view direction in FIG. 1.

Referring to FIG. 6, in some embodiments, an angle between the third surface 110c and the first surface 110a is an acute angle, while an angle between the third surface 110c and the second surface 110b is an obtuse angle. In other words, the third surface 110c is inclined relative to a plane perpendicular to either the first surface 110a or the second surface 110b. The inclined third surface 110c has a lower atomic packing density and a lower covalent bond areal density. Consequently, the bonds between adjacent atoms on the third surface 110c are less robust, which facilitates bonding between the passivation layer 111 on the third surface 110c and the dangling bonds of the third surface 110c. That is, the passivation layer 111 can more readily saturate the dangling bonds on the third surface 110c. Furthermore, the passivation layer 111 can also passivate other surface defects on the third surface 110c. This further enhances the ability of the passivation layer 111 to reduce the defect state density of the third surface 110c, thereby further decreasing recombination centers on the third surface 110c and lowering the carrier recombination probability. In other words, designing the third surface 110c of the cell 110 to be inclined rather than perpendicular, combined with the passivation function of the passivation layer 111, helps to further improve the passivation effect of the passivation layer 111 on the third surface 110c. This further reduces the probability of carrier recombination on the third surface 110c, increases carrier lifetime, and thereby further enhances the photoelectric conversion efficiency of the photovoltaic cell comprising the cell.

In some embodiments, the acute angle may range from 45° to 80°, for example, it may be 45°, 46°, 47°, 48°, 49°, 50°, 60°, 65°, 70°, 76°, or 80°. This configuration helps make the third surface 110c approach the fcc (111) crystal plane of the cell 110. Compared to other crystal planes, the fcc (111) plane has the lowest atomic packing density and the lowest covalent bond areal density, resulting in weaker bonds between adjacent atoms. Furthermore, designing the acute angle between the third surface 110c and the first surface 110a to be between 45° and 50° helps minimize the atomic packing density on the third surface 110c as much as possible, thereby maximizing the ability of the passivation layer 111 to saturate the dangling bonds on the third surface 110c. This further enhances the passivation effect of the passivation layer 111 on the third surface 110c, further reducing the recombination probability of carriers on the third surface 110c, increasing carrier lifetime, and thus further improving the photoelectric conversion efficiency of the photovoltaic cell comprising the cell.

Correspondingly, the obtuse angle ranges from 100° to 135°, for example, it can be 100°, 115°, 123°, 130°, or 135°. It can be understood that the third surface 110c may not be a perfectly flat surface, that is the obtuse and acute angles are not necessarily perfectly complementary.

FIG. 7 shows a structural view of a sixth type of solar cell provided in an embodiment of the present disclosure. Y-axis direction in FIG. 7 corresponds to the top-view direction in FIG. 1.

Referring to FIG. 7, in one example, the protective layer 121 can extend to the first surface 110a and the second surface 110b of the cell 110. In another example, the protective layer 121 can extend only to the first surface 110a of the cell 110. In yet another example, the protective layer 121 can extend only to the second surface 110b of the cell 110.

Since the encapsulation materials used in subsequent photovoltaic modules formed from the photovoltaic cells are difficult to achieve 100% isolation from the external environment, moisture may penetrate into the interior of the photovoltaic cell through the edge-sealing encapsulation material or backsheet under humid conditions. In such cases, glass within the encapsulation material can generate sodium ions. These sodium ions migrate towards the surface of the photovoltaic cell under an applied external electric field, causing potential induced degradation (PID) phenomenon, which reduces the photoelectric conversion efficiency of the photovoltaic cell. Configuring the protective layer 121 to extend to the first surface 110a of the cell 110 and/or to extend to the second surface 110b of the cell 110, can prevent moisture from reaching the third surface 110c and penetrating into the cell 110, thereby providing good anti-PID effects. Thus, even if the encapsulation materials of the photovoltaic modules cannot achieve perfect insulation, and moisture penetrates into the environment where the photovoltaic cell is located through the edge-sealing encapsulation materials, the protective layer 121 can still prevent sodium ions of the glass in the encapsulation materials from migrating towards the third surface 110c. This prevents the occurrence of PID phenomenon and maintains a high photoelectric conversion efficiency of the photovoltaic cell.

In some embodiments, the width by which the protective layer 121 extends from the edge of the cell 110 towards the center of the cell 110 ranges from 0 mm to 2 mm, for example, it can be 0 mm, 0.15 mm, 0.44 mm, 0.56 mm, 0.72 mm, 0.95 mm, 1 mm, 1.2 mm, 1.6 mm, 1.8 mm, or 2 mm. It can be understood that if the protective layer 121 extends too far from the edge of the cell 110 towards the center of the cell 110, the first surface 110a or the second surface 110b of the cell 110 may be shielded by the protective layer 121, thereby reducing the light absorption efficiency of the photovoltaic cell. Therefore, the width by which the protective layer 121 extends from the edge of the cell 110 towards the center of the cell 110 needs to be within an appropriate range.

In the photovoltaic cells provided by the embodiments of the present disclosure, the third surface 110c of the cell 110 is provided with a passivation layer 111. The passivation layer 111 contains a metal oxide material, and the metal oxide comprises at least one metal element of Al, Ti, Zn, Zr, Hf, Mo, W, and Ni. The metal element in the passivation layer 111 enables the passivation layer 111 itself to possess a high density of fixed charges, generating a strong electric field. This provides effective field-effect passivation for the third surface 110c, resulting in significant band bending between the passivation layer 111 and the third surface 110c. This hinders the migration of minority carriers to the third surface 110c and reduces the concentration of minority carriers at the third surface 110c, thereby lowering the recombination probability of majority and minority carriers at the third surface 110c and improving the efficiency of the photovoltaic cell comprising the cells 110. Furthermore, when the passivation layer 111 is only present on the third surface 110c of the cell 110, if the metal oxide in the passivation layer 111 is exposed to air for a long term, it tends to absorb moisture and adsorb airborne particles. This may result in the failure of the passivation layer 111, impairing the reliability of the photovoltaic cell. In the photovoltaic cells provided by the embodiments of the present disclosure, a protective layer 121 is formed over a surface of the passivation layer 111 away from the third surface 110c. The material of the protective layer 121 comprises a nitride, and the nitride comprises one element from Group III, for example, boron nitride, aluminum nitride, and gallium nitride. These nitrides are all atomic crystals, and therefore exhibit high stability, capable of protecting the inner passivation layer 111. This prevents the passivation layer 111 from failing due to prolonged exposure to air and moisture, thereby enhancing the stability of the photovoltaic cell.

Correspondingly, the embodiments of the present disclosure further provide a photovoltaic module comprising the photovoltaic cell according any one of the above embodiments. The following provides a detailed description of the photovoltaic module provided in another embodiment of the present disclosure in conjunction with the accompanying drawings. For parts that are identical or corresponding to those in the previous embodiments, reference may be made to the corresponding descriptions of the aforementioned embodiments, and further elaboration will not be provided here.

FIG. 8 is a schematic structural diagram of a photovoltaic module according to an embodiment of the present disclosure.

With reference to FIG. 8, the photovoltaic module provided by the embodiments of the present disclosure comprises a cell string, an encapsulation film 203, and a cover plate 204. The cell string comprises at least one photovoltaic cell 201 according to the foregoing embodiments. The encapsulation film 203 covers a surface of the cell string. The cover plate 204 covers a surface of the encapsulation film 203 away from the cell string.

Referring to FIG. 8, adjacent photovoltaic cells 201 can be connected by ribbons 202. A plurality of photovoltaic cells 201 can be electrically connected in series and/or parallel. The photovoltaic cell 201 according to the aforementioned embodiments mitigates power loss in the photovoltaic module with reduced current of the cell, thereby improving the photoelectric conversion efficiency of the photovoltaic module.

FIG. 8 illustrates one possible positional relationship between the photovoltaic cells 201, namely, where all positive electrodes of the photovoltaic cells 201 face the same side, and the ribbons 202 connect the different sides of two adjacent photovoltaic cells 201 respectively. In some embodiments, the photovoltaic cells may also be arranged with electrodes of different polarities facing the same side. That is, the electrodes of multiple adjacent photovoltaic cells are sequentially arranged in the order of first polarity, second polarity, first polarity, etc. In this case, the ribbons connect two adjacent photovoltaic cells on the same side.

In some embodiments, there is no gap between the photovoltaic cells, that is, the photovoltaic cells overlap one another.

The material of the encapsulation film 203 can be an organic encapsulation film such as ethylene-vinyl acetate (EVA) film, polyethylene octene copolymer film (POE), or polyvinyl butyral ester (PVB) film.

The cover plate 204 may be a glass cover plate, a plastic cover plate, or any other cover plate with a light-transmitting function.

In some embodiments, a surface, facing towards the encapsulation film 203, of the cover plate 204 may be uneven, thereby enhancing the utilization rate of incident light.

Correspondingly, some embodiments of the present disclosure further provide a method for manufacturing the photovoltaic cell, which can be used to manufacture the photovoltaic cell provided in the aforementioned embodiments. For parts that are the same as or similar to those in the previous embodiments, reference can be made to the detailed descriptions of the previous embodiments, and no further elaboration will be provided below.

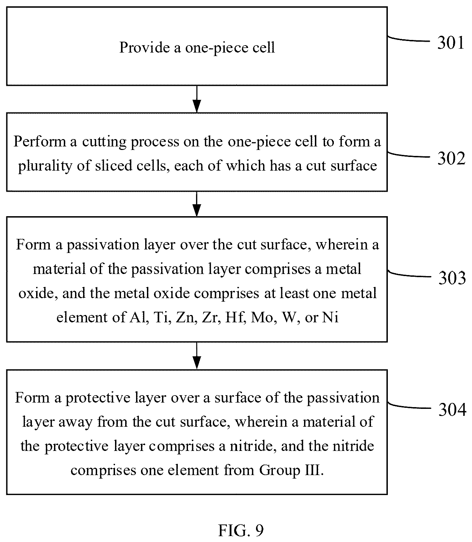

FIG. 9 is a flowchart of a method for manufacturing a photovoltaic cell according to an embodiment of the present disclosure.

With reference to FIG. 9, the method for manufacturing the photovoltaic cell provided by the embodiments of the present disclosure comprises the following.

In operation 301, a one-piece cell is provided.

In some embodiments, the one-piece cell may be any of PERC cell, PERT cell, TOPCon cell, HIT/HJT cell, or BC cell.

In some embodiments, the one-piece cell may be monocrystalline silicon photovoltaic cell, polycrystalline silicon photovoltaic cell, amorphous silicon photovoltaic cell, or multi-compound photovoltaic cell. Specifically, the multi-compound photovoltaic cell may be cadmium sulfide photovoltaic cell, gallium arsenide photovoltaic cell, copper indium selenide photovoltaic cell, or perovskite photovoltaic cell.

In operation 302, a cutting process is performed on the one-piece cell to form a plurality of sliced cells, each of which has a cut surface. The cutting process includes, but is not limited to, laser cutting.

In operation 303, a passivation layer is formed over the cut surface, wherein a material of the passivation layer comprises a metal oxide, and the metal oxide comprises at least one metal element of Al, Ti, Zn, Zr, Hf, Mo, W, and Ni.

The processes for forming the passivation layer include, but are not limited to, chemical vapor deposition (CVD), physical vapor deposition (PVD), and atomic layer deposition (ALD).

In operation 304, a protective layer is formed over a surface of the passivation layer away from the cut surface. A material of the protective layer comprises a nitride, and the nitride comprises one element from Group III.

The processes for forming the protective layer include, but are not limited to, CVD, PVD, and ALD.

In some embodiments, the protective layer and the passivation layer may be formed in one process step. By adjusting the reaction gas sources, the material types of the protective layer and passivation layer can be correspondingly controlled. Forming both the protective layer and passivation layer in one process step can improve the manufacturing efficiency of the photovoltaic cell.

In the method for manufacturing the photovoltaic cells according to the embodiments of the present disclosure, a passivation layer is formed over the third surface of the cell. The passivation layer contains a metal oxide material, and the metal oxide comprises at least one metal element of Al, Ti, Zn, Zr, Hf, Mo, W, and Ni. The metal element in the passivation layer enables the passivation layer itself to possess a high density of fixed charges, generating a strong electric field. This provides effective field-effect passivation for the third surface, resulting in significant band bending between the passivation layer and the third surface. This hinders the migration of minority carriers to the third surface and reduces the concentration of minority carriers at the third surface, thereby lowering the recombination probability of majority and minority carriers at the third surface and improving the efficiency of the photovoltaic cell comprising the cells. Furthermore, when the passivation layer is only present on the third surface of the cell, if the metal oxide in the passivation layer is exposed to air for a long term, it tends to absorb moisture and adsorb airborne particles. This may result in the failure of the passivation layer, impairing the reliability of the photovoltaic cell. In the method for manufacturing the photovoltaic cells according to the embodiments of the present disclosure, a protective layer is further formed over a surface of the passivation layer away from the third surface. The material of the protective layer comprises a nitride, and the nitride comprises one element from Group III elements consisting of scandium, yttrium, lanthanum and actinium, for example, boron nitride, aluminum nitride, and gallium nitride. These nitrides are all atomic crystals, and therefore exhibit high stability, capable of protecting the inner passivation layer. This prevents the passivation layer from failing due to prolonged exposure to air and moisture, thereby enhancing the stability of the photovoltaic cell.

Those of ordinary skill in the art can understand that the aforementioned embodiments are specific examples for implementing the present disclosure. In practical applications, various modifications can be made to them in form and detail without deviating from the scope of the present disclosure. A person skilled in the art may make various alterations and modifications without departing from the scope of the present disclosure, and thus the scope of protection of the present disclosure should be determined by the scope of the appended claims.

## Claims

1. A photovoltaic cell (110), comprising:
a first surface (110a), a second surface (110b) opposite to the first surface, and a third surface (110c) connecting the first surface with the second surface;
a passivation layer (111), formed over the third surface, the passivation layer including a metal oxide, and the metal oxide including at least one metal element of Al, Ti, Zn, Zr, Hf, Mo, W, and Ni; and
a protective layer (121), formed on a side of the passivation layer away from the third surface, the protective layer including a nitride, and the nitride including one element from Group III elements consisting of scandium, yttrium, lanthanum and actinium.

2. The photovoltaic cell according to claim 1, wherein the passivation layer comprises aluminum oxide.

3. The photovoltaic cell according to claim 1 or 2, wherein the protective layer comprises aluminum nitride.

4. The photovoltaic cell according to any one of claims 1 to 3, wherein an intermediate layer (131) is provided between the passivation layer and the protective layer, wherein the intermediate layer comprises aluminum.

5. The photovoltaic cell according to any one of claims 1 to 4, wherein the cell is a sliced cell obtained by performing a cutting process on a one-piece cell.

6. The photovoltaic cell according to claim 5, wherein the third surface is a cut surface of the sliced cell.

7. The photovoltaic cell according to any one of claims 1 to 6, wherein in a direction perpendicular to the third surface, a thickness ratio of the passivation layer to the protective layer ranges from 0.7 to 2.

8. The photovoltaic cell according to claim 7, wherein in the direction perpendicular to the third surface, a thickness of the protective layer ranges from 10 nm to 100 nm.

9. The photovoltaic cell according to any one of claims 1 to 8, wherein the passivation layer comprises a first sub-passivation layer and a second sub-passivation layer, wherein the first sub-passivation layer is located on the third surface, the second sub-passivation layer is located on a side of the first sub-passivation layer away from the third surface, the first sub-passivation layer comprises silicon oxide, and the second sub-passivation layer comprises the metal oxide.

10. The photovoltaic cell according to claim 9, wherein the passivation layer further comprises a third sub-passivation layer between the first sub-passivation layer and the second sub-passivation layer, wherein the third sub-passivation layer comprises a metal silicon oxide, and the metal silicon oxide comprises a same metal element as the second sub-passivation layer.

11. The photovoltaic cell according to claim 9, wherein in the direction perpendicular to the third surface, a thickness of the protective layer is greater than or equal to a thickness of the second sub-passivation layer.

12. The photovoltaic cell according to any one of claims 1 to 11, wherein the protective layer extends to the first surface of the cell and/or to the second surface of the cell.

13. The photovoltaic cell according to claim 10, wherein along a direction from the first sub-passivation layer toward the second sub-passivation layer, a silicon content in the third sub-passivation layer gradually decreases, and a metal element content in the third sub-passivation layer gradually increases.

14. The photovoltaic cell according to claim 12, wherein a width by which the protective layer extends from an edge of the cell towards a center of the cell ranges from 0 mm to 2 mm.

15. A photovoltaic module, comprising:
a cell string, comprises at least one photovoltaic cell according to any one of claims 1 to 14;
an encapsulation film covering a surface of the cell string; and
a cover plate covering a surface of the encapsulation film away from the cell string.
